# EUROPEAN PATENT APPLICATION

(11) **EP 4 711 849 A1**
(43) Date of publication of application: **18.03.2026**
(21) Application number: 24306528.1
(22) Date of filing: 17.09.2024
(51) Int. Cl.: G03F 7/027, G03F 7/038, G03F 7/00, G03F 7/004, B33Y 10/00, B33Y 70/00

(54) **ADDITIVES FOR PREVENTING BUBBLE FORMATION DURING 3D PRINTING**

(71) Applicant: ARKEMA FRANCE, 92800 Puteaux (FR)
(72) Inventor: CHAMPAGNE, Clémentine, ARDMORE, PA 19003 (US); ANDERSSON, Jonathan, Daniel, BOULDER, CO 80301 (US)
(74) Representative: Renard, Emmanuelle

(57) **Abstract**

The present invention relates to curable compositions comprising additives useful for preventing the formation and entrapment of bubbles during 3D printing and to methods for preventing or restricting bubble formation and entrapment in 3D printed compositions. More specifically, this invention pertains to a curable composition comprising: (A) a free-radically polymerizable resin comprising at least one (meth)acrylate-functionalized compound; (B) a free radical photoinitiator; (C) optionally, at least one cationically polymerizable compound and a cationic photoinitiator; and (D) at least one specific wetting agent present in an amount of 1 to 15 weight percent based on the weight of the curable composition. The additives described herein are useful across a wide range of 3D printed articles because the presence of bubbles in the curable composition may impact either or both of the operability or the aesthetics of a 3D printed article.

## Description

### TECHNICAL FIELD

The present invention relates to curable compositions comprising additives useful for preventing or restricting the formation and entrapment of bubbles during 3D printing and to methods for preventing or restricting bubble formation and entrapment in 3D printed compositions.

### BACKGROUND OF THE INVENTION

Vat polymerization is a form of 3D printing which comprises stereolithography (SLA) and Digital Light Processing (DLP). Both techniques use photopolymer resins to produce parts which are cured under UV light. They allow high precision manufacturing of parts having a small size and/or a complex geometry without the need to invest in expensive tooling.

In these processes, it is often critical to entirely eliminate or minimize defects in the 3D printed parts. One source of defects in 3D printed parts is bubbles, which are sometimes formed in the curable composition as it is cured due to the movement of liquid as the cured product is being fabricated. If formed and then entrapped in the cured composition, bubbles can impact the accuracy of the outer surface of the 3D printed part, which can in turn significantly impact the suitability of the parts for the desired application. For example, 3D printed articles for use in the dental market (such as night guards and teeth straighteners) require precise manufacturing, so even a low extent of bubble formation and entrapment might not be tolerable. Similarly, 3D printed parts for use in the medical field (such as prosthetic limbs) also require precise manufacturing. Bubbles can also cause premature failure of the 3D printed part. In addition, bubbles adversely impact clarity and can cause aesthetic defects. Such aesthetic defects would be undesirable in many 3D printed parts, such as jewelry, frames for eyewear, footwear, and automotive parts.

The adverse impacts caused by bubbles in vat photopolymerization are described in "Limiting Defect in Vat Photopolymerization via Visual-Guided in-situ Repair," Zhao, L., et al., Additive Manufacturing, 79 (2024) 103947, which proposes a repair method to attempt to eliminate them, using a scraper and an associated controlling algorithm. Similarly, European Patent No. 1 769 902 suggests sweeping the surface between each layer of the 3D printed composition with a computer-controlled recoater blade to level the resin and prepare the working surface for curing. This method adds a step to the 3D printing process and may thus cause an undesirably increased wait time between the formation of layers.

As noted in "A Review of Defects in Vat Photopolymerization Additive-Manufactured Ceramics: Characterization, Control, and Challenges," Zhang, K., et al., Journal of the European Ceramic Society, 44 (2024) 1361-1384, the formation of bubbles has been identified as a primary cause of pore defects in SLA additive-manufactured ceramics. Bubbles are also identified in having a detrimental effect on print quality in "A Review on Vat Polymerization Technology: Manufacturing Process, Associated Materials, Design Considerations, Post-processing Methods and Common Applications," Naveed, M. Y., IRJET, volume 8, issue 7 (July, 2021) 1353-1359.

It would thus be desirable to reduce bubble formation in the 3D printing process without decreasing throughput and creating waste from failures. Furthermore, it would be generally desirable to use additives that are readily biodegradable. It would further be needed to provide additives which are readily compatible with, and soluble in, acrylate and epoxy binders. The latter indeed provide strength and flexibility to the 3D printed parts, which furthermore have surfaces with plastic appearance enabling more realistic modeling of various items.

The inventors have now shown that this need can be satisfied by adding specific surfactants into the resin composition.

U.S. Patent No. 9,457,515 discloses a liquid radiation curable resin comprising: one or more epoxy functional components; one or more oxetanes; one or more polyols; one or more radically curable (meth)acrylate components; one or more impact modifiers; one or more free radical photoinitiators; and one or more cationic photoinitiators. Optional additives include wetting agents, such as Silwet^{®} 7600 or BYK^{®} 348, which are polyalkyleneoxide-modified polydimethylsiloxanes. Similar compositions are provided in US2017/327632. In both these documents, the formation of bubbles is not discussed. In any case, the amount of surfactant is between 0.15 and 0.3%, which is insufficient to prevent bubble formation.

In addition, US-9,353,284 provides binder compositions intended to be applied by 3D printing onto particulate materials. These binder compositions may contain acrylate monomers and a polyether-modified acryl-functionalized polydimethylsiloxane surfactant (BYK^{®} UV3500) to allow the fluid binder to wet out onto the particulate material and reduce surface defects. Again, this surfactant is present in an amount of 0.05% only in the binder, which is insufficient to prevent bubble formation.

Finally, WO00/56543 discloses polymeric films prepared from curable compositions based on free radically polymerizable monomers such as (meth)acrylate monomers. The films may have a structured topography designed to reduce air bubbles and thus surface defects, which may be provided by any technique such as stereolithography. They may further include a plasticizer such as a polyalkoxylated ether of aliphatic alcohol (Tergitol^{®} 15-S-9) in an amount of 40 weight percent relative to the weight of the curable composition. These compounds have also been described as defoaming agents by their supplier. However, it has not been suggested to use them for this purpose in this document.

Surprisingly, it has now been found that the addition of a low amount of polyalkoxylated ether of aliphatic alcohol to a curable composition based on (meth)acrylate compounds overcomes the drawbacks associated with known approaches to avoid problems caused by bubbles during 3D printing of this composition.

### SUMMARY OF THE INVENTION

This invention pertains to a curable composition comprising:
A) a free-radically polymerizable resin comprising at least one (meth)acrylate-functionalized compound selected from (meth)acrylate-functionalized monomers, (meth)acrylate-functionalized oligomers and mixtures thereof;
B) a free radical photoinitiator;
C) optionally, at least one cationically polymerizable compound and a cationic photoinitiator; and
D) at least one wetting agent present in an amount of 1 to 15 weight percent based on the weight of the curable composition, wherein the wetting agent has a structure of formula (I): 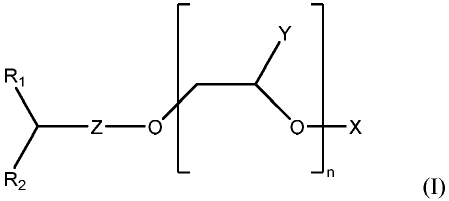 wherein:
   X is H or SO₃Na or PO₃H or PO₃Na,
   Y is H or CH₃ or CH₂-CH₃,
   n is 1 to 40,
   Z is CH₂ or a bond,
   R₁ is a linear or branched alkyl chain having from 6 to 16 carbon atoms,
   R₂ is a linear or branched alkyl chain having from 1 to 14 carbon atoms,
   provided that the total number of carbon atoms in R₁ and R₂ ranges from 7 to 31.

This invention is also directed to a process for the preparation of a cured product, comprising curing the curable composition as defined above, preferably by exposing the curable composition to radiation such as UV, near-UV, visible, infrared and/or near-infrared radiation or to an electron beam.

It further pertains to a method for preventing or restricting bubble formation upon 3D printing of a curable composition comprising (A) a free-radically polymerizable resin comprising at least one (meth)acrylate-functionalized compound selected from (meth)acrylate-functionalized monomers, (meth)acrylate-functionalized oligomers and mixtures thereof; (B) a free radical photoinitiator; and (C) optionally, at least one cationically polymerizable compound and a cationic photoinitiator, comprising adding to said curable composition at least one wetting agent, in an amount of 1 to 15 weight percent based on the weight of the curable composition, wherein said wetting agent is as defined above.

Still another object of this invention is the use of a wetting agent as defined above to prevent or restrict bubble formation upon curing of a curable composition comprising (A) a free-radically polymerizable resin comprising at least one (meth)acrylate-functionalized compound selected from (meth)acrylate-functionalized monomers, (meth)acrylate-functionalized oligomers and mixtures thereof; (B) a free radical photoinitiator; and (C) optionally, at least one cationically polymerizable compound and a cationic photoinitiator.

### DETAILED DESCRIPTION OF THE INVENTION

In the context of this description, when ranges are given they should be understood as encompassing their lower and upper limits. In addition, unless otherwise indicated, all percentages are to be understood as weight percents.

This invention pertains to a curable composition comprising: (A) a free-radically polymerizable resin comprising at least one (meth)acrylate compound selected from (meth)acrylate-functionalized monomers, (meth)acrylate-functionalized oligomers and mixtures thereof; and (B) a free radical photoinitiator. It also includes certain wetting agents in certain amounts which have been shown to prevent or restrict the formation of bubbles when 3D printing the curable composition.

The composition of this invention is curable by free radical curing but it may also be curable by both free radical curing and cationic curing and thus constitute a "hybrid composition". Thus, according to an embodiment of the invention, the composition further comprises (C) a cationically polymerizable resin and a cationic photoinitiator. In another embodiment, the composition does not comprise any (C) cationically polymerizable resin and cationic photoinitiator.

### Curable composition

The constituents of this curable composition will now be described in further details.

### (Meth)acrylate compound

Component (A) of the curable composition of this invention comprises or consists of at least one (meth)acrylate-functionalized compound. The term "(meth)acrylate group" encompasses acrylate groups (-O-CO-CH=CH₂) and methacrylate groups (-O-CO-C(CH₃)=CH₂).

As used herein, the term "(meth)acrylate-functionalized compound" encompasses both monomers comprising at least one (meth)acrylate group and oligomers comprising et least one (meth)acrylate group.

Preferably, the (meth)acrylate-functionalized compound does not comprise any amino group. As used herein, the term "amino group" refers to a primary, secondary or tertiary amine group, but does not include any other type of nitrogen-containing group such as an amide, carbamate (urethane), urea, or sulfonamide group.

The (meth)acrylate-functionalized monomer may have a molecular weight of less than 600 g/mol, in particular from 100 to 550 g/mol, more particularly 200 to 500 g/mol.

The (meth)acrylate-functionalized monomer may have 1 to 6 (meth)acrylate groups, in particular 1 to 5 (meth)acrylate groups, more particularly 1 to 3 (meth)acrylate groups.

The (meth)acrylate-functionalized monomers may comprise a mixture of (meth)acrylate-functionalized monomers having different functionalities. For example the (meth)acrylate-functionalized monomer may comprise a mixture of a (meth)acrylate-functionalized monomer containing a single acrylate or methacrylate group per molecule (referred to herein as "mono(meth)acrylate-functionalized monomers") and a (meth)acrylate-functionalized monomer containing 2 or more, preferably 2 or 3, acrylate and/or methacrylate groups per molecule. In another example, the (meth)acrylate-functionalized monomers may comprise a mixture of at least one mono(meth)acrylate-functionalized monomer and at least one (meth)acrylate-functionalized monomer containing 3 or more, preferably 4 or more, (meth)acrylate groups per molecule.

The (meth)acrylate functionalized monomer may comprise a mono(meth)acrylate-functionalized monomer. The mono(meth)acrylate-functionalized monomer may advantageously function as a reactive diluent and reduce the viscosity of the composition of the invention.

Examples of suitable mono(meth)acrylate-functionalized monomers include, but are not limited to, mono-(meth)acrylate esters of aliphatic alcohols (wherein the aliphatic alcohol may be straight chain, branched or alicyclic and may be a mono-alcohol, a di-alcohol or a polyalcohol, provided only one hydroxyl group is esterified with (meth)acrylic acid); mono-(meth)acrylate esters of aromatic alcohols (such as phenols, including alkylated phenols); mono-(meth)acrylate esters of alkylaryl alcohols (such as benzyl alcohol); mono-(meth)acrylate esters of oligomeric and polymeric glycols such as diethylene glycol, triethylene glycol, dipropylene glycol, tripropylene glycol, polyethylene glycol, and polypropylene glycol); mono-(meth)acrylate esters of monoalkyl ethers of glycols and oligoglycols; mono-(meth)acrylate esters of alkoxylated (e.g., ethoxylated and/or propoxylated) aliphatic alcohols (wherein the aliphatic alcohol may be straight chain, branched or alicyclic and may be a mono-alcohol, a di-alcohol or a polyalcohol, provided only one hydroxyl group of the alkoxylated aliphatic alcohol is esterified with (meth)acrylic acid); mono-(meth)acrylate esters of alkoxylated (e.g., ethoxylated and/or propoxylated) aromatic alcohols (such as alkoxylated phenols); caprolactone mono(meth)acrylates; and the like.

The following monomers are specific examples of mono(meth)acrylate-functionalized monomers suitable for use in the curable compositions of the present invention: methyl (meth)acrylate; ethyl (meth)acrylate; n-propyl (meth)acrylate; n-butyl (meth)acrylate; isobutyl (meth)acrylate; n-hexyl (meth)acrylate; 2-ethylhexyl (meth)acrylate; n-octyl (meth)acrylate; isooctyl (meth)acrylate; n-decyl (meth)acrylate; n-dodecyl (meth)acrylate; tridecyl (meth)acrylate; tetradecyl (meth)acrylate; hexadecyl (meth)acrylate; 2-hydroxyethyl (meth)acrylate; 2- and 3-hydroxypropyl (meth)acrylate; 2-methoxyethyl (meth)acrylate; 2-ethoxyethyl (meth)acrylate; 2- and 3-ethoxypropyl (meth)acrylate; tetrahydrofurfuryl (meth)acrylate; alkoxylated tetrahydrofurfuryl (meth)acrylate; 2-(2-ethoxyethoxy)ethyl (meth)acrylate; cyclohexyl (meth)acrylate; glycidyl (meth)acrylate; isodecyl (meth)acrylate; lauryl (meth)acrylate; 2-phenoxyethyl (meth)acrylate; alkoxylated phenol (meth)acrylates; alkoxylated nonylphenol (meth)acrylates; cyclic trimethylolpropane formal (meth)acrylate; isobomyl (meth)acrylate; tricyclodecanemethanol (meth)acrylate; tert-butylcyclohexanol (meth)acrylate; trimethylcyclohexanol (meth)acrylate; diethylene glycol monomethyl ether (meth)acrylate; diethylene glycol monoethyl ether (meth)acrylate; diethylene glycol monobutyl ether (meth)acrylate; triethylene glycol monoethyl ether (meth)acrylate; ethoxylated lauryl (meth)acrylate; methoxy polyethylene glycol (meth)acrylates; 3-(2-hydroxyalkyl)oxazolidinone (meth)acrylates; and combinations thereof.

Alternatively or in addition, the (meth)acrylate functionalized monomer may comprise a (meth)acrylate-functionalized monomer containing two or more (meth)acrylate groups per molecule.

Examples of suitable (meth)acrylate-functionalized monomer containing two or more (meth)acrylate groups per molecule include acrylate and methacrylate esters of polyhydric alcohols (organic compounds containing two or more, e.g., 2 to 6, hydroxyl groups per molecule). Specific examples of suitable polyhydric alcohols include C₂₋₂₀ alkylene glycols (glycols having a C₂₋₁₀ alkylene group may be preferred, in which the carbon chain may be branched; e.g., ethylene glycol, trimethylene glycol, 1,2-propylene glycol, 1,2-butanediol, 1,3-butanediol, 2,3-butanediol, 1,4-butanediol, 1,5-pentanediol, 1,6-hexanediol, 1,8-octanediol, 1,9-nonanediol, 1,12-dodecanediol, cyclohexane-1,4-dimethanol, bisphenols, and hydrogenated bisphenols, as well as alkoxylated (e.g., ethoxylated and/or propoxylated) derivatives thereof), diethylene glycol, glycerin, alkoxylated glycerin, triethylene glycol, dipropylene glycol, tripropylene glycol, trimethylolpropane, alkoxylated trimethylolpropane, ditrimethylolpropane, alkoxylated ditrimethylolpropane, pentaerythritol, alkoxylated pentaerythritol, dipentaerythritol, alkoxylated dipentaerythritol, cyclohexanediol, alkoxylated cyclohexanediol, cyclohexanedimethanol, alkoxylated cyclohexanedimethanol, norbornene dimethanol, alkoxylated norbomene dimethanol, norbornane dimethanol, alkoxylated norbornane dimethanol, polyols containing an aromatic ring, cyclohexane-1,4-dimethanol ethylene oxide adducts, bis-phenol ethylene oxide adducts, hydrogenated bisphenol ethylene oxide adducts, bisphenol propylene oxide adducts, hydrogenated bisphenol propylene oxide adducts, cyclohexane-1,4-dimethanol propylene oxide adducts, sugar alcohols and alkoxylated sugar alcohols. Such polyhydric alcohols may be fully or partially esterified with (meth)acrylic acid, (meth)acrylic anhydride, (meth)acryloyl chloride or the like, provided they contain at least two (meth)acrylate functional groups per molecule. As used herein, the term "alkoxylated" refers to compounds containing one or more oxyalkylene units (e.g., oxyethylene and/or oxypropylene units). An oxyalkylene unit corresponds to the general structure -R-O-, wherein R is a divalent aliphatic unit such as -CH₂CH₂- or -CH₂CH(CH₃)-. For example, an alkoxylated compound may contain from 1 to 30 oxyalkylene units per molecule.

Exemplary (meth)acrylate-functionalized monomers containing two or more (meth)acrylate groups per molecule may include bisphenol A di(meth)acrylate; hydrogenated bisphenol A di(meth)acrylate; ethylene glycol di(meth)acrylate; diethylene glycol di(meth)acrylate; triethylene glycol di(meth)acrylate; tetraethylene glycol di(meth)acrylate; polyethylene glycol di(meth)acrylate; propylene glycol di(meth)acrylate; dipropylene glycol di(meth)acrylate; tripropylene glycol di(meth)acrylate; tetrapropylene glycol di(meth)acrylate; polypropylene glycol di(meth)acrylate; polytetramethylene glycol di(meth)acrylate; 1,2-butanediol di(meth)acrylate; 2,3-butanediol di(meth)acrylate; 1,3-butanediol di(meth)acrylate; 1,4-butanediol di(meth)acrylate; 1,5-pentanediol di(meth)acrylate; 1,6-hexanediol di(meth)acrylate; 1,8-octanediol di(meth)acrylate; 1,9-nonanediol di(meth)acrylate; 1,10-nonanediol di(meth)acrylate; 1,12-dodecanediol di(meth)acrylate; neopentyl glycol di(meth)acrylate; 2-methyl-2,4-pentanediol di(meth)acrylate; polybutadiene di(meth)acrylate; cyclohexane-1,4-dimethanol di(meth)acrylate; tricyclodecane dimethanol di(meth)acrylate; metallic di(meth)acrylates; modified metallic di(meth)acrylates; glyceryl di(meth)acrylate; glyceryl tri(meth)acrylate; trimethylolethane tri(meth)acrylate; trimethylolethane di(meth)acrylate; trimethylolpropane tri(meth)acrylate; trimethylolpropane di(meth)acrylate; pentaerythritol di(meth)acrylate; pentaerythritol tri(meth)acrylate; pentaerythritol tetra(meth)acrylate, di(trimethylolpropane) diacrylate; di(trimethylolpropane) triacrylate; di(trimethylolpropane) tetraacrylate, sorbitol penta(meth)acrylate; di(pentaerythritol) tetraacrylate; di(pentaerythritol) pentaacrylate; di(pentaerythritol) hexa(meth)acrylate; tris (2-hydroxyethyl) isocyanurate tri(meth)acrylate; as well as the alkoxylated (e.g., ethoxylated and/or propoxylated) derivatives thereof; and combinations thereof.

The (meth)acrylate-functionalized compound may further comprise or consist of an oligomer in order to enhance the flexibility, strength and/or modulus, among other attributes, of a cured polymer prepared using the curable composition of the present invention. The (meth)acrylate functionalized oligomer may have up to 18 (meth)acrylate groups, in particular 2 to 6 (meth)acrylate groups, more particularly 2 to 6 acrylate groups. The (meth)acrylate functionalized oligomer may have a number average molecular weight equal or more than 600 g/mol, in particular 800 to 15,000 g/mol, more particularly 1,000 to 5,000 g/mol.

In particular, the (meth)acrylate-functionalized oligomer may be selected from the group consisting of (meth)acrylate-functionalized urethane oligomers (sometimes also referred to as "urethane (meth)acrylate oligomers," "polyurethane (meth)acrylate oligomers" or "carbamate (meth)acrylate oligomers"), (meth)acrylate-functionalized epoxy oligomers (sometimes also referred to as "epoxy (meth)acrylate oligomers"), (meth)acrylate-functionalized polydiene oligomers (sometimes also referred to as "polydiene (meth)acrylate oligomers"), (meth)acrylate-functionalized polycarbonate oligomers (sometimes also referred to as "polycarbonate (meth)acrylate oligomers"), (meth)acrylate-functionalized polyester oligomers (sometimes also referred to as "polyester (meth)acrylate oligomers"), acrylic (meth)acrylate oligomers and mixtures thereof.

Preferred (meth)acrylate-functionalized oligomers comprise or consist of (methacrylate)-functionalized urethane oligomers.

In various embodiments, the polyurethane (meth)acrylate oligomers may be prepared by reacting aliphatic and/or aromatic diisocyanates with OH group-terminated polyester polyols (including aromatic, aliphatic and mixed aliphatic/aromatic polyester polyols), polyether polyols, polycarbonate polyols, polycaprolactone polyols, polyorganosiloxane polyols (e.g., polydimethylsiloxane polyols), or polydiene polyols (e.g., polybutadiene polyols), or combinations thereof to form isocyanate-functionalized oligomers which are then reacted with hydroxy-functionalized (meth)acrylates such as hydroxyethyl acrylate or hydroxyethyl methacrylate to provide terminal (meth)acrylate groups. In yet another embodiment, a polyisocyanate may be first reacted with a polyol, including any of the aforementioned types of polyols, to obtain an isocyanate-functionalized polyol, which is thereafter reacted with a hydroxyl-functionalized (meth)acrylate to yield a polyurethane (meth)acrylate. Alternatively, all the components may be combined and reacted at the same time.

For example, the polyurethane (meth)acrylate oligomers may contain two, three, four or more (meth)acrylate functional groups per molecule.

Advantageously, the (meth)acrylate-functionalized urethane oligomer comprises an aliphatic (meth)acrylate-functionalized urethane oligomer having two (meth)acrylate groups.

Suitable polyurethane (meth)acrylate oligomers include, for example, aliphatic polyester-based urethane di- and tetra-acrylate oligomers, aliphatic polyether-based urethane di- and tetra-acrylate oligomers, as well as aliphatic polyester/polyether-based urethane di- and tetra-acrylate oligomers.

Exemplary polyester (meth)acrylate oligomers include the reaction products of acrylic or methacrylic acid or mixtures thereof with hydroxyl group-terminated polyester polyols. The reaction process may be conducted such that all or essentially all of the hydroxyl groups of the polyester polyol have been (meth)acrylated, particularly in cases where the polyester polyol is difunctional. The polyester polyols can be made by polycondensation reactions of polyhydroxyl functional components (in particular, diols) and polycarboxylic acid functional compounds (in particular, dicarboxylic acids and anhydrides). The polyhydroxyl functional and polycarboxylic acid functional components can each have linear, branched, cycloaliphatic or aromatic structures and can be used individually or as mixtures. Examples of suitable epoxy (meth)acrylates include the reaction products of acrylic or methacrylic acid or mixtures thereof with an epoxy resin (polyglycidyl ether or ester). The epoxy resin may, in particular, by selected from bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxy cyclohexanecarboxylate, 2-(7-oxabicyclo[4.1.0]heptan-3-yl)spiro[1,3-dioxane-5,3'-7-oxabicyclo[4.1.0]heptane], bis(3,4-epoxycyclohexylmethyl)adipate, vinylcyclohexene oxide, 4-vinylepoxycyclohexane, bis(3,4-epoxy-6-methylcyclohexylmethyl) adipate, 3,4-epoxy-6-methylcyclohexyl-3',4'-epoxy-6'-methylcyclohexanecarboxylate, methylenebis(3,4-epoxycyclohexane), dicyclopentadiene diepoxide, di(3,4-epoxycyclohexylmethyl) ether of ethylene glycol, ethylenebis(3,4-epoxycyclohexanecarboxylate), 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether, polyglycidyl ethers of a polyether polyol obtained by the addition of one or more alkylene oxides to an aliphatic polyhydric alcohol such as ethylene glycol, propylene glycol, and glycerol, diglycidyl esters of aliphatic long-chain dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, epoxidized soybean oil, epoxybutylstearic acid, epoxyoctylstearic acid, epoxidized linseed oil, epoxidized polybutadiene, and the like.

Suitable polyether (meth)acrylate oligomers include, but are not limited to, the condensation reaction products of acrylic or methacrylic acid or synthetic equivalents or mixtures thereof with polyetherols which are polyether polyols (such as polyethylene glycol, polypropylene glycol or polytetramethylene glycol). Suitable polyetherols can be linear or branched substances containing ether bonds and terminal hydroxyl groups. Polyetherols can be prepared by ring opening polymerization of cyclic ethers such as tetrahydrofuran or alkylene oxides (e.g., ethylene oxide and/or propylene oxide) with a starter molecule. Suitable starter molecules include water, polyhydroxyl functional materials, and polyester polyols. Suitable acrylic (meth)acrylate oligomers (sometimes also referred to in the art as "acrylic oligomers") include oligomers which may be described as substances having an oligomeric acrylic backbone which is functionalized with one or (meth)acrylate groups (which may be at a terminus of the oligomer or pendant to the acrylic backbone). The acrylic backbone may be a homopolymer, random copolymer or block copolymer comprised of repeating units of acrylic monomers. The acrylic monomers may be any monomeric (meth)acrylate such as C1-C6 alkyl (meth)acrylates as well as functionalized (meth)acrylates such as (meth)acrylates bearing hydroxyl, carboxylic acid and/or epoxy groups. Acrylic (meth)acrylate oligomers may be prepared using any procedures known in the art, such as by oligomerizing monomers, at least a portion of which are functionalized with hydroxyl, carboxylic acid and/or epoxy groups (e.g., hydroxyalkyl(meth)acrylates, (meth)acrylic acid, glycidyl (meth)acrylate) to obtain a functionalized oligomer intermediate, which is then reacted with one or more (meth)acrylate-containing reactants to introduce the desired (meth)acrylate functional groups.

The curable composition of the invention may comprise 10 to 97.5%, in particular 20 to 85%, more particularly 40 to 70%, by weight of (meth)acrylate-functionalized compound based on the total weight of the curable composition.

### Free radical photoinitiator

Non-limiting types of radical photoinitiators suitable for use in the curable compositions of the present invention include, for example, benzoins, benzoin ethers, acetophenones, α-hydroxy acetophenones, benzyl, benzyl ketals, anthraquinones, phosphine oxides, acylphosphine oxides, α-hydroxyketones, phenylglyoxylates, α-aminoketones, benzophenones, thioxanthones, xanthones, acridine derivatives, phenazene derivatives, quinoxaline derivatives, triazine compounds, benzoyl formates, aromatic oximes, metallocenes, acylsilyl or acylgermanyl compounds, camphorquinones, polymeric derivatives thereof, and mixtures thereof.

Examples of suitable radical photoinitiators include, but are not limited to, 2-methyl anthraquinone, 2-ethylanthraquinone, 2-chloroanthraquinone, 2-benzyanthraquinone, 2-t-butylanthraquinone, 1,2-benzo-9,10-anthraquinone, benzyl, benzoins, benzoin ethers, benzoin, benzoin methyl ether, benzoin ethyl ether, benzoin isopropyl ether, alpha-methylbenzoin, alpha-phenylbenzoin, Michler's ketone, acetophenones such as 2,2-dialkoxybenzophenones and 1-hydroxyphenyl ketones, benzophenone, 4,4'-bis-(diethylamino) benzophenone, acetophenone, 2,2-diethyloxyacetophenone, diethyloxyacetophenone, 2-isopropylthioxanthone, thioxanthone, diethyl thioxanthone, 1,5-acetonaphthylene, benzil ketone, α-hydroxy keto, 2,4,6-trimethylbenzoyldiphenyl phosphine oxide, benzyl dimethyl ketal, 2,2-dimethoxy-1,2-diphenylethanone, 1-hydroxycylclohexyl phenyl ketone, 2-methyl-1-[4-(methylthio) phenyl]-2-morpholinopropanone-1, 2-hydroxy-2-methyl-1-phenyl-propanone, oligomeric α-hydroxy ketone, benzoyl phosphine oxides, phenylbis(2,4,6-trimethylbenzoyl)phosphine oxide, ethyl(2,4,6-trimethylbenzoyl)phenyl phosphinate, anisoin, anthraquinone, anthraquinone-2-sulfonic acid, sodium salt monohydrate, (benzene) tricarbonylchromium, benzil, benzoin isobutyl ether, benzophenone/1-hydroxycyclohexyl phenyl ketone, 50/50 blend, 3,3',4,4'-benzophenonetetracarboxylic dianhydride, 4-benzoylbiphenyl, 2-benzyl-2-(dimethylamino)-4'-morpholinobutyrophenone, 4,4'-bis(diethylamino)benzophenone, 4,4'-bis(dimethylamino)benzophenone, camphorquinone, 2-chlorothioxanthen-9-one, dibenzosuberenone, 4,4'-dihydroxybenzophenone, 2,2-dimethoxy-2-phenylacetophenone, 4-(dimethylamino)benzophenone, 4,4'-dimethylbenzil, 2,5-dimethylbenzophenone, 3,4-dimethylbenzophenone, diphenyl(2,4,6-trimethylbenzoyl)phosphine oxide /2-hydroxy-2-methylpropiophenone, 50/50 blend, 4'-ethoxyacetophenone, 2,4,6-trimethylbenzoyldiphenylphophine oxide, phenyl bis(2,4,6-trimethyl benzoyl)phosphine oxide, ferrocene, 3'-hydroxyacetophenone, 4'-hydroxyacetophenone, 3-hydroxybenzophenone, 4-hydroxybenzophenone, 1-hydroxycyclohexyl phenyl ketone, 2-hydroxy-2-methylpropiophenone, 2-methylbenzophenone, 3-methylbenzophenone, methybenzoyl-formate, 2-methyl-4'-(methylthio)-2-morpholinopropiophenone, phenanthrenequinone, 4'-phenoxyacetophenone, (cumene)cyclopentadienyl iron(ii) hexafluorophosphate, 9,10-diethoxy and 9,10-dibutoxyanthracene, 2-ethyl-9,10-dimethoxyanthracene, thioxanthen-9-one and combinations thereof.

In preferred compositions of the invention, a radical photoinitiator having Norrish type I activity may be used, such as a phosphine oxide or an acetophenone.

The curable composition of the invention may comprise from 0.5 to 5%, in particular from 1 to 4%, more particularly from 1.5 to 3.5 %, by weight of photoinitiator based on the total weight of the curable composition.

### Cationically polymerizable compound

The term "cationically polymerizable compound" means a compound comprising a polymerizing functional group which polymerizes via a cationic mechanism, for example a heterocyclic group or a carbon-carbon double bond substituted with an electrodonating group. In a cationic polymerization mechanism, a cationic initiator forms a Brønsted or Lewis acid species that binds to the cationically polymerizable compound which then becomes reactive and leads to chain growth by reaction with another cationically polymerizable compound.

The cationically polymerizable compound may be selected from epoxides, oxetanes, oxolanes, cyclic acetals, cyclic lactones, thiiranes, thietanes, spiro orthoesters, vinyl ethers, and mixtures thereof.

In a preferred embodiment, the cationically polymerizable compound may be selected from epoxides, especially alkoxylated cycloaliphatic epoxides, oxetanes and mixtures thereof.

Suitable epoxides capable of being cationically polymerized are glycidyl ethers, in particular mono-, di-, tri- and polyglycidyl ether compounds, and alicyclic epoxy compounds including those comprising residue of carboxylic acids such as, for example, alkylcarboxylic acid residual groups, alkylcycloalkylcarboxylic acid residual groups and alkylene dicarboxylic acid residual groups. For example, the epoxy-functionalized compounds may be bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(7-oxabicyclo[4.1.0]heptan-3-yl)spiro[1,3-dioxane-5,3'-7-oxabicyclo[4.1.0]heptane], bis(3,4-epoxycyclohexylmethyl) adipate, vinylcyclohexene oxide, 4-vinylepoxycyclohexane, 4-vinylcyclohexene dioxide, bis(3,4-epoxy-6-methylcyclohexylmethyl)adipate, 3,4-epoxy-6-methylcyclohexyl-3',4'-epoxy-6'-methylcyclohexanecarboxylate, methylenebis(3,4-epoxycyclohexane), dicyclopentadiene diepoxide, di(3,4-epoxycyclohexylmethyl) ether of ethylene glycol, ethylenebis(3,4-epoxycyclohexanecarboxylate), epoxyhexahydrodioctylphthalate, epoxy-hexahydro-di-2-ethylhexyl phthalate, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether, polyglycidyl ethers of polyether polyol obtained by the addition of one or more alkylene oxides to aliphatic polyhydric alcohols such as ethylene glycol, propylene glycol, and glycerol, diglycidyl esters of aliphatic long-chain dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, epoxidized soybean oil, epoxybutylstearic acid, epoxyoctylstearic acid, epoxidized linseed oil, epoxidized polybutadiene, and the like.

A preferred alkoxylated cycloaliphatic epoxide is Uvicure^{®} S105 which is available from SARTOMER and has the following formula:

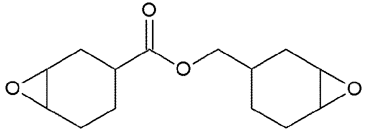

Suitable oxetanes capable of being cationically polymerized include trimethylene oxide, 3,3-dimethyloxetane, 3,3-dichloromethyloxetane, 3-ethyl-3-phenoxymethyloxetane, and bis(3-ethyl-3-methyloxy)butane, 3-ethyl-3-oxetanemethanol.

In a preferred embodiment, the oxetane has the following formula: 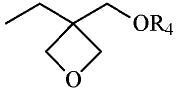 wherein R₄ is selected from H, alkyl, aryl, alkylaryl, (meth)acryloyl, -CH₂-oxetanyl-CH₂-CH₃, -L₁-O-CH₂-oxetanyl-CH₂-CH₃;
Li is a divalent linker, in particular-CH₂-Ph-Ph-CH₂ or -CH₂-Ph-CH₂-[O-CH₂-Ph-CH₂]_{f}-Ph is phenylene;
f is 0 to 10.

In particular, the oxetane may be such that R₄ is H, benzyl or -CH₂-oxetanyl-CH₂-CH₃, preferably R₄ is H or -CH₂-oxetanyl-CH₂-CH₃. Example of such a compound is sold by SARTOMER as Uvicure^{®} S130.

Suitable oxolanes capable of being cationically polymerized include tetrahydrofuran and 2,3-dimethyltetrahydrofuran.

Suitable cyclic acetals capable of being cationically polymerized include trioxane, 1,3-dioxolane, and 1,3,6-trioxacyclooctane.

Suitable cyclic lactones capable of being cationically polymerized include β-propiolactone and ε-caprolactone.

Suitable thiiranes capable of being cationically polymerized include ethylene sulfide, 1,2-propylene sulfide, and thioepichlorohydrin.

Suitable thietanes capable of being cationically polymerized include 3,3-dimethylthietane.

Suitable spiro orthoesters capable of being cationically polymerized are compounds obtained by the reaction of an epoxy compound and a lactone.

Suitable vinyl ethers are aromatic, aliphatic or cycloaliphatic vinyl ethers and also silicon-containing vinyl ethers. These are compounds having at least one, preferably at least two, vinyl ether groups in the molecule. Examples of vinyl ethers suitable for use in the compositions according to the invention include triethylene glycol divinyl ether, 1,4-cyclohexanedimethanol divinyl ether, 4-hydroxybutyl vinyl ether, the propenyl ether of propylene carbonate, dodecyl vinyl ether, tert-butyl vinyl ether, tert-amyl vinyl ether, cyclohexyl vinyl ether, 2-ethylhexyl vinyl ether, ethylene glycol monovinyl ether, butanediol monovinyl ether, hexanediol monovinyl ether, 1,4-cyclohexanedimethanol mono-vinyl ether, diethylene glycol monovinyl ether, ethylene glycol divinyl ether, ethylene glycol butylvinyl ether, butane-1,4-diol divinyl ether, hexanediol divinyl ether, diethylene glycol divinyl ether, triethylene glycol divinyl ether, triethylene glycol methylvinyl ether, tetra-ethylene glycol divinyl ether, Pluriol-E-200 divinyl ether, polytetrahydrofuran divinyl ether-290, trimethylolpropane trivinyl ether, dipropylene glycol divinyl ether, octadecyl vinyl ether, (4-cyclohexyl-methyleneoxyethene)-glutaric acid methyl ester and (4-butoxyethene)-iso-phthalic acid ester. Preferred vinyl ethers are ethylene glycol divinyl ether, triethylene glycol divinyl ether and trimethylolpropane trivinyl ether.

When present, the cationically-polymerizable compound used in this invention may be a single cationically-polymerizable compound or a mixture of at least two cationically-polymerizable compounds. Preferred component (C) for use in this invention comprise a mixture of at least one alkoxylated cycloaliphatic epoxide and at least one oxetane. Oxetanes may serve as reactive diluents and provide high curing speed and also high solvent resistance in compositions with alkoxylated cycloaliphatic epoxides. The weight ratio between the oxetane and the alkoxylated cycloaliphatic epoxide may range from 20:80 to 80:20, in particular from 30:70 to 70:30, more particularly from 40:60 to 60:40.

The curable composition of the invention may comprise 10 to 80%, preferably 10 to 50%, in particular 15 to 40%, by weight of cationically polymerizable compound based on the total weight of the curable composition.

### Cationic photoinitiator

In the case where the curable composition of this invention comprises at least one cationically polymerizable compound, the composition further comprises at least one cationic photoinitiator, which may be selected from an onium salt or a metallocene salt for example, more particularly ahalonium salt, a sulfonium salt (e.g. a triarylsulfonium salt such as triarylsulfonium hexafluoroantimonate salt), a sulfoxonium salt, a diazonium salt, a ferrocene salt, and mixtures thereof.

In addition, a sensitizer may be introduced in the curable composition in order to extend the sensitivity of the photoinitiator to longer wavelengths. For example, the sensitizer may absorb light at longer or shorter wavelengths than the photoinitiator and be capable of transferring the energy to the photoinitiator and revert to its ground state. Examples of suitable sensitizers include anthracenes and carbazoles.

### Wetting agent

The curable composition of this invention comprises a wetting agent, the function of which is to prevent bubbles from forming in the first place. This compound is thus not used as a defoamer or deaerator, which typically reduce bubbles in the final product by aiding in the "popping" of bubbles quickly after they are formed. Furthermore, this invention does neither require the use of increased wait times or recoating, nor the addition of a defoaming agent to this composition.

Moreover, it has been found that the use of wetting agents described herein lead to stable formulations that have good performance over time, contrary to other wetting agents and especially defoamers. This appears to be achieved by the improved solubility of the wetting agents described herein, whereas polyether-modified silicones, for instance, have a tendency to phase separate, thereby impacting the stability of the formulation.

The wetting agent of this invention is a hydrocarbon having a structure (I): 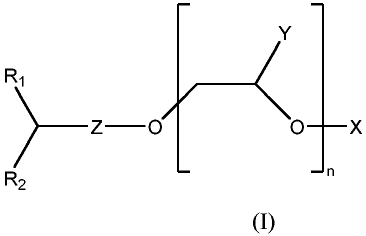 wherein:
X is H or SO₃Na or PO₃H or PO₃Na,
Y is H or CH₃ or CH₂-CH₃,
n is 1 to 40,
Z is CH₂ or a bond,
R₁ is a linear or branched alkyl chain from 6 to 16 carbon atoms,
R₂ is a linear or branched alkyl chain from 1 to 14 carbon atoms,
provided that the total number of carbon atoms in R₁ and R₂ ranges from 7 to 31.

Exemplary commercially-available wetting agents suitable for use herein include surfactants sold under the trademark TERGITOL^{®} by Dow. As used herein, references to 'a wetting agent' could mean a single wetting agent or a combination of multiple wetting agents.

The nature and amount of the wetting agent used in this invention will be easily adjusted by the skilled artisan depending on the monomers and/or oligomers used and on the desired extent of reduction in bubble formation, which itself depends on the particular application. For instance, 3D printed parts which are pigmented and need not satisfy aesthetic criteria, such as prototyping models, may comprise a few bubbles, whereas 3D-printed parts which are subject to repeated forces, such as high-pressure molding or tooling applications, should contain as few bubbles as possible to avoid premature failure.

The invention thus includes all embodiments in which some reduction in bubble formation is shown relative to a cured base matrix (i.e., without any wetting agent).

In the case where significant reduction in bubble formation is expected, it is preferred to use wetting agents having the structure (I) and having an HLB of at least 6, preferably of at least 8, more preferably of at least 10, still preferably of at least 12 and even more preferably of at least 14, such as at least 16. Alternatively, the wetting agents of this invention have a mean number n of oxyalkylene units per molecule which is preferably higher than 2, more preferably higher then 6 and still more preferably higher than 10 or even higher than 14.

According to an embodiment of the invention, the (D) wetting agent is present in an amount of up to the solubility limit of the wetting agent in the curable composition at the application temperature, which may be room temperature (e.g., 25°C). The (D) wetting agent is present in an amount of up to 15 weight percent, preferably up to 10 weight percent, more preferably up to 9 weight percent and still preferably up to 8 weight percent based on the weight of the of the curable composition.

Moreover, it is preferable to include at least 2 weight percent, preferably at least 3 weight percent and more preferably at least 4 weight percent of the wetting agent, based on the weight of the curable composition (including the wetting agent). In some situations, especially when the HLB is less than 12, it is preferable to include at least 8 weight percent of the wetting agent, based on the weight of the curable composition. In other situations, especially when the HLB is of at least 16, it is preferable to include at least 1 weight percent of the wetting agent, based on the weight of the curable composition.

Thus, the composition of this invention typically comprises from 2 to 10, preferably from 3 to 9, more preferably from 4 to 8 weight percent of the wetting agent, based on the weight of the curable composition.

For instance, the concentration of wetting agent having the structure (I) in the curable composition may be: (a) at least 2.5 wt%, preferably at least 3 wt%, and more preferably at least 7.5 wt% for wetting agents having an HLB of from 6 to 8; (b) at least 2.5 wt%, preferably at least 3 wt%, and more preferably at least 7.5 wt% for wetting agents having an HLB of above 8 to 12; (c) at least 2.5 wt%, preferably at least 3 wt%, more preferably 4.5 wt% for wetting agents having an HLB of from 12 to 15.5; (d) at least 0.5 wt%, preferably at least 2.5 wt%, and more preferably at least 4.5 wt% for wetting agents having an HLB of above 15.5 to 20; and (e) at least 0.5 wt%, preferably at least 2.5 wt%, and more preferably at least 4 wt% for wetting agents having an HLB of above 20.

According to an embodiment of the invention, the ratio of carbon atoms in R₁ (C1) to the number of carbon atoms in R₂ (C2) in structure (I) is from about 1:9 to about 9:1, preferably from about 2:8 to about 8:2, and more preferably from about 3:7 to about 7:3. Embodiments of the invention include any range of such ratios extending from any lower limit to any upper limit set forth herein, such as from about 1:9 to about 8:2 and about 3:7 to about 9:1. According to a preferred embodiment of the invention, Y is H. In another embodiment, Y is CH₃.

According to a preferred embodiment of the invention, X is H.

### Additives

The curable composition of the present invention may comprise at least one additive.

In particular, the additive may be selected from amine synergists, antioxidants/photostabilizers, light blockers/absorbers, polymerization inhibitors, foam inhibitors, flow or leveling agents, colorants, pigments, surfactants (other than the wetting agents of this invention), slip additives, fillers, chain transfer agents, thixotropic agents, matting agents, impact modifiers, waxes, mixtures thereof, and any other additives conventionally used in the coating, sealant, adhesive, molding, 3D printing or ink arts.

In preferred embodiments of the invention, the curable composition is a liquid at 25°C. In various embodiments of the invention, the curable compositions described herein are formulated to have a viscosity of less than 10,000 mPa.s (cP), or less than 5,000 mPa.s (cP), or less than 4,000 mPa.s (cP), or less than 3,000 mPa.s (cP), or less than 2,500 mPa.s (cP), or less than 2,000 mPa.s (cP), or less than 1,500 mPa.s (cP), or less than 1,000 mPa.s (cP) or even less than 500 mPa.s (cP) as measured at 25°C using a Brookfield viscometer, model DV-II, using a 27 spindle (with the spindle speed varying typically between 20 and 200 rpm, depending on viscosity). In advantageous embodiments of the invention, the viscosity of the curable composition is from 200 to 5,000 mPa.s (cP), or from 200 to 2,000 mPa.s (cP), or from 200 to 1,500 mPa.s (cP), or from 200 to 1,000 mPa.s (cP) at 25°C. Relatively high viscosities can provide satisfactory performance in applications where the curable composition is heated above 25°C, such as in three-dimensional printing operations or the like which employ machines having heated resin vats.

### Method

The process for the preparation of a cured product according to the invention comprises curing the composition as described previously by exposing the composition to radiation or to an electron beam. More particularly, the composition may be cured by exposing the composition to UV, near-UV, visible, infrared and/or near-infrared radiation or to an electron beam.

Curing may be accelerated or facilitated by supplying energy to the curable composition, such as by heating the curable composition. Thus, the cured product may be deemed the reaction product of the curable composition, formed by curing. A curable composition may be partially cured by exposure to actinic radiation, with further curing being achieved by heating the partially cured article. For example, an article formed from the curable composition (e.g., a 3D printed article) may be heated at a temperature of from 40°C to 120°C for a period of time of from 5 minutes to 12 hours.

Prior to curing, the curable composition may be applied to a substrate surface in any known conventional manner, for example, by spraying, knife coating, roller coating, casting, drum coating, dipping, and the like and combinations thereof. Indirect application using a transfer process may also be used. A substrate may be any commercially relevant substrate, such as a high surface energy substrate or a low surface energy substrate, such as a metal substrate or plastic substrate, respectively. The substrates may comprise metal, paper, cardboard, glass, thermoplastics such as polyolefins, polycarbonate, acrylonitrile butadiene styrene (ABS), and blends thereof, composites, wood, leather and combinations thereof. When used as an adhesive, the curable composition may be placed between two substrates and then cured, the cured composition thereby bonding the substrates together to provide an adhered article. Curable compositions in accordance with the present invention may also be formed or cured in a bulk manner (e.g., the curable composition may be cast into a suitable mold and then cured).

The cured product obtained with the process of the invention may be any 3D-printed article whose operability or aesthetics may be adversely impacted by defects caused by the presence of bubbles in the curable composition.

In a preferred embodiment, the cured product is a 3D printed part selected from a jewelry product, a frame for eyewear, a brush for personal care products, footwear, protective wear and equipment, a part of terrestrial, nautical or aerospace vehicle, an electronic part, a seal or a gasket.

In particular, the cured product may be obtained with a 3D printing process and thus be a 3D-printed article. Three-dimensional (3D) printing (also referred to as additive manufacturing) is a process in which a 3D digital model is manufactured by the accretion of construction material. The 3D printed object is created by utilizing the computer-aided design (CAD) data of an object through sequential construction of two dimensional (2D) layers or slices that correspond to cross-sections of 3D objects. Stereolithography (SL) is one type of additive manufacturing where a liquid resin is hardened by selective exposure to a radiation to form each 2D layer. The radiation can be in the form of electromagnetic waves or an electron beam. The most commonly applied energy source is UV, near-UV, visible, infrared and/or near-infrared radiation.

Non-limiting examples of suitable 3D printing processes include stereolithography (SLA); digital light process (DLP); liquid crystal device (LCD); inkjet head (or multijet) printing; Continuous Liquid Interface Production (CLIP); extrusion type processes such as continuous fiber 3D printing and cast-in-motion 3D printing; and volumetric 3D printing. The building method may be "layer by layer" or continuous. The liquid may be in a vat, or deposited with an inkjet or gel deposition, for example.

The 3D-printed articles may be free-standing/self-supporting and may consist essentially of or consist of a composition in accordance with the present invention that has been cured. The three-dimensional article may also be a composite, comprising at least one component consisting essentially of or consisting of a cured composition as previously mentioned as well as at least one additional component comprised of one or more materials other than such a cured composition (for example, a metal component or a thermoplastic component or inorganic filler or fibrous reinforcement). The curable compositions of the present invention may also be used in a 3D-printing operation together with another material which functions as a scaffold or support for the article formed from the curable composition of the present invention.

Thus, the curable compositions of the present invention are useful in the practice of various types of three-dimensional fabrication or printing techniques, including methods in which construction of a three-dimensional object is performed in a step-wise or layer-by-layer manner. In such methods, layer formation may be performed by solidification (curing) of the curable composition under the action of exposure to radiation, such as visible, UV or other actinic irradiation. For example, new layers may be formed at the top surface of the growing object or at the bottom surface of the growing object. The curable compositions of the present invention may also be advantageously employed in methods for the production of three-dimensional objects by additive manufacturing wherein the method is carried out continuously. For example, the object may be produced from a liquid interface. Suitable methods of this type are sometimes referred to in the art as "continuous liquid interface (or interphase) product (or printing)" ("CLIP") methods. Such methods are described, for example, in WO 2014/126830; WO 2014/126834; and WO 2014/126837, the entire disclosure of which is incorporated herein by reference in its entirety for all purposes.

The process for the preparation of a 3D-printed article may comprise the steps of:
a) providing (e.g., coating) a first layer of a curable composition in accordance with the present invention onto a surface;
b) curing the first layer, at least partially, to provide a cured first layer;
c) providing (e.g., coating) a second layer of the curable composition onto the cured first layer;
d) curing the second layer, at least partially, to provide a cured second layer adhered to the cured first layer; and
e) repeating steps c) and d) a desired number of times to build up the three-dimensional article.

In some embodiments, the present invention provides a process comprising the steps of:
a) providing (e.g., coating) a first layer of a curable composition in accordance with the present invention and in liquid form onto a surface;
b) exposing the first layer imagewise to actinic radiation to form a first exposed imaged cross-section, wherein the radiation is of sufficient intensity and duration to cause at least partial curing of the layer in the exposed areas;
c) providing (e.g., coating) an additional layer of the curable composition onto the previously exposed imaged cross-section;
d) exposing the additional layer imagewise to actinic radiation to form an additional imaged cross-section, wherein the radiation is of sufficient intensity and duration to cause at least partial curing of the additional layer in the exposed areas and to cause adhesion of the additional layer to the previously exposed imaged cross-section;
e) repeating steps c) and d) a desired number of times to build up the three-dimensional article.

Alternatively, the process for the preparation of a 3D-printed article may comprise the steps of:
a) providing a carrier and an optically transparent member having a build surface, the carrier and build surface defining a build region therebetween;
b) filling the build region with a composition as defined above;
c) continuously or intermittently curing part of the composition in the build region according to the method as defined above to form a cured composition; and
d) continuously or intermittently advancing the carrier away from the build surface to form the 3D-printed article from the cured composition.

According to an embodiment of the invention, the wait time between curing the first layer and curing the second layer may be less than 5 seconds, preferably less than 1 second, more preferably less than 0.5 seconds, and most preferably less than 0.1 seconds. It is generally desirable to minimize the wait time. The wait time depends on the surface area of the substrate and the viscosity of the curable composition. Smaller substrates and less viscous materials allow for less wait time needed between curing because the material will level more quickly.

According to an embodiment of the invention, the method does not comprise the use of vacuum applied to the curable composition or a cured layer during the method.

After the 3D article has been printed, it may be subjected to one or more post-processing steps. The post-processing steps can be selected from one or more of the following steps: removal of any printed support structures, washing with water and/or organic solvents to remove residual resins, and post-curing using thermal treatment and/or actinic radiation either simultaneously or sequentially. The post-processing steps may be used to transform the freshly printed article into a finished, functional article ready to be used in its intended application.

Although the invention is illustrated and described herein with reference to specific embodiments, the invention is not intended to be limited to the details shown. Rather, various modifications may be made in the details within the scope and range of equivalents of the claims and without departing from the invention.

The invention is illustrated with the following non-limiting examples.

### EXAMPLES

A study was carried out to assess the impact on bubble formation in a 3D printing formulation of four different wetting agents according to this invention, having a structure (I) : 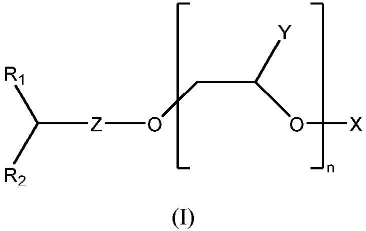 wherein R₁ and R₂ together comprise from 11 to 15 carbon atoms, X = Y = H and Z is a bond, and a comparative wetting agent which is a polyether-modified silicone having an HLB value of 14.3 (Silwet^{®} L-7600).

Specifically, the following wetting agents of this invention were tested:

**Table 1**

| Wetting agent | HLB value | n |
|---|---|---|
| Tergitol^{®} 15-S-3 | 8.0 | 3 |
| Tergitol^{®} 15-S-7 | 12.1 | 7 |
| Tergitol^{®} 15-S-15 | 15.4 | 15 |
| Tergitol^{®} 15-S-40 | 18.0 | 40 |

Solubility at room temperature was confirmed as excellent for all wetting agents at loadings ranging from 0.2 to 10%.

All the wetting agents tested were incorporated into a 3D printing base formulation in various amounts (weight percents) as shown in Table 2 below.

**Table 2**

| Component / function | Control | IE-1 | IE-2 | IE-3 | IE-4 |
|---|---|---|---|---|---|
| SR833S⁽¹⁾ (SARTOMER) / (meth)acrylate compound | 64.81 | 64.17 | 62.91 | 61.68 | 58.74 |
| Uvicure S105⁽²⁾ (SARTOMER) / cationically polymerizable compound | 19.44 | 19.25 | 18.87 | 18.50 | 17.62 |
| Uvicure S130⁽³⁾ (SARTOMER) / cationically polymerizable compound | 8.33 | 8.25 | 8.09 | 7.93 | 7.55 |
| Speedcure BKL⁽⁴⁾ (SARTOMER) / free-radical photoinitiator | 3.70 | 3.67 | 3.60 | 3.52 | 3.36 |
| Speedcure 976⁽⁵⁾ (SARTOMER) / cationic photoinitiator | 3.70 | 3.67 | 3.60 | 3.52 | 3.36 |
| Wetting agent | | 0.99 | 2.93 | 4.83 | 9.37 |

| | | | | | |
|---|---|---|---|---|---|
| ⁽¹⁾ Tricyclodecanedimethanol diacrylate ⁽²⁾ 7-oxabicyclo[4.1.0]hept-3-ylmethyl 7-oxabicyclo[4.1.0]heptane-3-carboxylate ⁽³⁾ 3-ethyloxetane-3-methanol ⁽⁴⁾ 2,2-dimethoxy-1,2-phenylacetophenone ⁽⁵⁾ (sulfanediyldibenzene-4,1-diyl)bis(diphenylsulfonium) bis(hexafluoroantimonate) in propylene carbonate | | | | | |

Parts were 3D printed with a 355nm top-down stereolithography apparatus (Raplas PR450) at a vat temperature of approximately 20-25°C. No recoater was used in the 3D printing process. A post-hatch delay of 0.2 seconds was used, along with a 5 second per-dip delay. Parts were dipped 3mm into the vat in between layers, with a build platform movement speed of 5 mm/sec. Parts were removed from the build platform and cleaned via sonication for ten minutes in isopropyl alcohol. Parts were dried in air, and then post-cured for one minute per side in an IntelliRay 400 at 100% intensity at the top height utilizing a 400W UVA bulb. Parts were then imaged with a microscope and rated for entrapped air in the 3D printed parts comparatively, wherein 5 corresponds to the product with the lowest amount of bubbles and 1 corresponds to the product with the highest amount of bubbles.

The results of this assessment are shown in Table 3 below.

**Table 3**

| | Wt.% | | | |
|---|---|---|---|---|
| | 2.9 | 4.8 | 9.4 | 0 |
| Tergitol^{®} 15-S-3 | 2 | 2 | 5 | 1 |
| Tergitol^{®} 15-S-7 | 3 | 4 | 5 | 1 |
| Tergitol^{®} 15-S-15 | 3 | 5 | 5 | 1 |
| Tergitol^{®} 15-S-40 | 3 | 5 | 5 | 1 |
| Silwet^{®} L-7600 | 1 | 3 | 5 | 1 |

As can be seen from Table 3, a clear trend of decreased bubble formation with increased loading and increased HLB of the additive is seen. In particular, bubble formation is reduced as both (1) wetting agents having a higher HLB are used and (2) wetting agents in higher amounts are used. In addition, the impact of using a wetting agent having the structure (I) is demonstrated. In addition, these data show that Silwet L-7600 requires a higher loading than the Tergitol additives to achieve similar technical effects.

More specifically, a wetting agent of structure (I) having an HLB of 8 provides some improvement over the control at 2.9 wt% loading and very significant improvement at 9.4 wt% loading. Moreover, a wetting agent of structure (I) having an HLB of 12.1 provides very significant improvement at 9.4 wt% loading. Finally, a wetting agent of structure (I) having an HLB of 15.4 or 18 provide very significant improvement at 4.8 wt% loading (and above).

It should be understood that any two quantitative values assigned to a property may constitute a range of that property, and all combinations of ranges formed from all stated quantitative values of a given property are contemplated in this disclosure. The subject matter disclosed herein has been described in detail and by reference to specific embodiments. It should be understood that any detailed description of a component or feature of an embodiment does not necessarily imply that the component or feature is essential to the particular embodiment or to any other embodiment.

## Claims

1. A curable composition comprising:
A) a free-radically polymerizable resin comprising at least one (meth)acrylate-functionalized compound selected from (meth)acrylate-functionalized monomers, (meth)acrylate-functionalized oligomers and mixtures thereof;
B) a free radical photoinitiator;
C) optionally, at least one cationically polymerizable compound and a cationic photoinitiator; and
D) at least one wetting agent present in an amount of 1 to 15 weight percent based on the weight of the curable composition, wherein the wetting agent has a structure of formula (I): 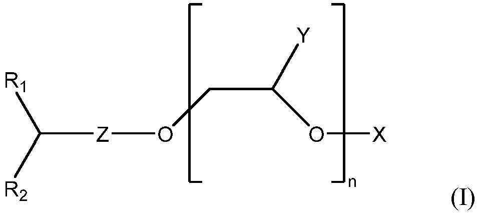 wherein:
X is H or SO₃Na or PO₃H or PO₃Na,
Y is H or CH₃ or CH₂-CH₃,
n is 1 to 40,
Z is CH₂ or a bond,
R₁ is a linear or branched alkyl chain having from 6 to 16 carbon atoms,
R₂ is a linear or branched alkyl chain having from 1 to 14 carbon atoms,
provided that the total number of carbon atoms in R₁ and R₂ ranges from 7 to 31.

2. The composition of claim 1, wherein the ratio of carbon atoms in R1 (C 1) to the number of carbon atoms in R2 (C2) is from about 1:9 to about 9:1, preferably from about 2:8 to about 8:2, and more preferably from about 3:7 to about 7:3.

3. The composition of claim 1 or 2, wherein Y is H.

4. The composition of claim 1 or 2, wherein Y is CH₃.

5. The composition of any of claims 1 to 4, wherein X is H.

6. The composition of any of claims 1 to 5, wherein the wetting agent has an HLB value of at least 6, preferably at least 8, more preferably at least 10, more preferably at least 12, and most preferably at least 14.

7. The composition of any of claims 1 to 5, which comprises from 2 to 10, preferably from 3 to 9, more preferably from 4 to 8 weight percent of wetting agent, based on the weight of the curable composition.

8. A process for the preparation of a cured product, comprising curing the curable composition according to any one of claims 1 to 7, preferably by exposing the curable composition to radiation such as UV, near-UV, visible, infrared and/or near-infrared radiation or to an electron beam.

9. The process of claim 8 wherein the cured product is obtained with a 3D printing process.

10. The process according to claim 8 or 9, wherein the cured product is a 3D printed article.

11. The process according to claim 10, wherein the 3D printed article is a jewelry product, a frame for eyewear, a brush for personal care products, footwear, protective wear and equipment, a part of terrestrial, nautical or aerospace vehicle, an electronic part, a seal or a gasket.

12. The process of any of claims 8 to 11, comprising curing a first layer of the curable composition to form a first cured layer, curing a second layer of the curable composition to form a second cured layer coated on the first cured layer with a wait time between curing the first layer and curing the second layer of less than 5 seconds, preferably less than 1 second, more preferably less than 0.5 seconds, and most preferably less than 0.1 seconds.

13. The process of claim 12, which does not comprise the use of vacuum applied to the curable composition or a cured layer during the method.

14. A method for preventing or restricting bubble formation upon 3D printing of a curable composition comprising: (A) a free-radically polymerizable resin comprising at least one (meth)acrylate-functionalized compound selected from (meth)acrylate-functionalized monomers, (meth)acrylate-functionalized oligomers and mixtures thereof, (B) a free radical photoinitiator; and (C) optionally, at least one cationically polymerizable compound and a cationic photoinitiator, comprising adding to said curable composition at least one wetting agent, in an amount of 1 to 15 weight percent based on the weight of the curable composition, wherein said wetting agent is as defined in any one of claims 1 to 7.

15. Use of a wetting agent is as defined in any one of claims 1 to 7 to prevent or restrict bubble formation upon curing of a curable composition comprising: (A) a free-radically polymerizable resin comprising at least one (meth)acrylate-functionalized compound selected from (meth)acrylate-functionalized monomers, (meth)acrylate-functionalized oligomers and mixtures thereof, (B) a free radical photoinitiator; and (C) optionally, at least one cationically polymerizable compound and a cationic photoinitiator.
